# EUROPEAN PATENT APPLICATION

(11) **EP 4 567 880 A1**
(43) Date of publication of application: **11.06.2025**
(21) Application number: 24857457.6
(22) Date of filing: 16.05.2024
(51) Int. Cl.: H01L 23/473, H05K 7/20, G06F 1/20

(54) **HEAT DISSIPATION DEVICE AND METHOD FOR MANUFACTURING SAME**

(30) Priority: 25.08.2023 CN 202311085306
(71) Applicant: ZTE CORPORATION, Shenzhen, Guangdong 518057 (CN)
(72) Inventor: TAO, Cheng, Shenzhen, Guangdong 518057 (CN); YANG, Xiaoping, Shenzhen, Guangdong 518057 (CN); ZHANG, Yuantong, Shenzhen, Guangdong 518057 (CN); LIU, Fan, Shenzhen, Guangdong 518057 (CN); ZHOU, Xiaodong, Shenzhen, Guangdong 518057 (CN); HU, Chengyu, Shenzhen, Guangdong 518057 (CN); WEI, Jinjia, Shenzhen, Guangdong 518057 (CN); ZHANG, Yonghai, Shenzhen, Guangdong 518057 (CN)
(74) Representative: Ziebig Hengelhaupt Intellectual Property Attorneys Patentanwaltskanzlei PartGmbB
(86) International application number: PCT/CN2024/093589
(87) International publication number: WO 2025/044302

(57) **Abstract**

The present application discloses a heat dissipation apparatus and a method for manufacturing the heat dissipation apparatus. The heat dissipation apparatus includes a cover body, a flow-uniformizing component and a bottom board component. The bottom board component includes a heat dissipation chamber, a plurality of heat conduction members are arranged in a first region of the heat dissipation chamber at a first interval, and a plurality of heat conduction members are arranged in a second region of the heat dissipation chamber at a second interval; a third region of the flow-uniformizing component includes a plurality of first flow-uniformizing channels and a plurality of first liquid drain channels, the first flow-uniformizing channels are provided with a plurality of first liquid outlet holes at a third interval, the first liquid outlet holes communicate with the first flow-uniformizing channels and the first region, a fourth region of the flow-uniformizing component includes a plurality of second flow-uniformizing channels and a plurality of second liquid drain channels, the second flow-uniformizing channels are provided with a plurality of second liquid outlet holes at a fourth interval, the second liquid outlet holes communicate with the second flow-uniformizing channels and the second region, and the first liquid drain channels communicate with the first region and the second flow-uniformizing channels; and the cover body is provided with a liquid inlet and a liquid outlet, the liquid inlet communicates with the first flow-uniformizing channels, and the second liquid drain channels communicate with the second region and the liquid outlet.

## Description

### CROSS-REFERENCE TO RELATED APPLICATIONS

The present application claims priority to Chinese Patent Application No. 202311085306.7 filed to the Chinese Patent Office on August 25, 2023, and entitled "HEAT DISSIPATION APPARATUS AND METHOD FOR MANUFACTURING HEAT DISSIPATION APPARATUS", the entire contents of which are incorporated herein by reference.

### TECHNICAL FIELD

The present application relates to the field of heat dissipation devices, in particular to a heat dissipation apparatus and a method for manufacturing the heat dissipation apparatus.

### BACKGROUND

With the rapid development of social informatization, more requirements are put forward for the performance of electronic devices, which leads to the continuous increase of single-chip functional modules, and chips show a trend of increasing integration level and area at the same time, which makes the non-uniform power distribution of the chips become more and more obvious, resulting in a plurality of local "hot spots" of high heat flux of the chips. The temperature inhomogeneity caused by the local "hot spots" will cause thermal stress of largearea chips, resulting in chip warping and even fracture, which seriously affects the reliability and life of the chips.

However, heat dissipation apparatuses in the related art mostly perform heat dissipation on uniform heat sources, and have a poor heat dissipation effect on non-uniform heating chips.

### SUMMARY

The present application discloses a heat dissipation apparatus and a method for manufacturing the heat dissipation apparatus, which can improve a heat dissipation effect on non-uniform heating chips.

In order to solve the above problem, the present application adopts the following technical solution.

In a first aspect, an embodiment of the present application discloses a heat dissipation apparatus, including: a cover body, a flow-uniformizing component and a bottom board component, wherein the bottom board component includes a heat dissipation chamber, a plurality of heat conduction members are arranged in a first region of the heat dissipation chamber at a first interval, a plurality of heat conduction members are arranged in a second region of the heat dissipation chamber at a second interval, wherein the first interval is smaller than the second interval; the flow-uniformizing component at least covers the heat dissipation chamber, a third region of the flow-uniformizing component includes a plurality of first flow-uniformizing channels and a plurality of first liquid drain channels, the first flow-uniformizing channels and the first liquid drain channels are arranged alternately, the first flow-uniformizing channels are provided with a plurality of first liquid outlet holes at a third interval, the first liquid outlet holes communicate with the first flow-uniformizing channels and the first region, a fourth region of the flow-uniformizing component includes a plurality of second flow-uniformizing channels and a plurality of second liquid drain channels, the second flow-uniformizing channels and the second liquid drain channels are arranged alternately, the second flow-uniformizing channels are provided with a plurality of second liquid outlet holes at a fourth interval, the second liquid outlet holes communicate with the second flow-uniformizing channels and the second region, and the first liquid drain channels communicate with the first region and the second flow-uniformizing channels; the cover body covers the flow-uniformizing component, the cover body is provided with a liquid inlet and a liquid outlet, the liquid inlet communicates with the first flow-uniformizing channels, and the second liquid drain channels communicate with the second region and the liquid outlet; and in a case that a chip is in a mounted state, a face of the bottom board component away from the flow-uniformizing component makes contact with the chip, a fifth region of the chip corresponds to the first region, a sixth region of the chip corresponds to the second region, wherein a temperature of the fifth region is higher than a temperature of the sixth region.

In a second aspect, an embodiment of the present application discloses a method for manufacturing a heat dissipation apparatus, including: bonding a liquid separation board, a flow jetting board, a frame board and a bottom board into a first body according to an order; and connecting a cover body with the first body.

The embodiment of the present application provides the heat dissipation apparatus, relatively densely arranged heat conduction members are arranged in the first region of the heat dissipation chamber of the bottom board component, relatively sparsely arranged heat conduction members are arranged in the second region of the heat dissipation chamber of the bottom board component, in the case where the chip is in the mounted state, a high heat flux region of the chip corresponds to the first region, a low heat flux region of the chip corresponds to the second region, in addition, the flow-uniformizing component covers the heat dissipation chamber, the third region of the flow-uniformizing component corresponds to the first region of the heat dissipation chamber, the fourth region of the flow-uniformizing component corresponds to the second region of the heat dissipation chamber, the plurality of first flow-uniformizing channels in the third region of the flow-uniformizing component communicate with the liquid inlet in the cover body, the first flow-uniformizing channels are provided with the plurality of first liquid outlet holes at the third interval, the first liquid outlet holes communicate with the first flow-uniformizing channels and the first region, the plurality of first liquid drain channels in the third region of the flow-uniformizing component communicate with the first region and the plurality of second flow-uniformizing channels in the fourth region of the flow-uniformizing component, the second flow-uniformizing channels are provided with the plurality of second liquid outlet holes at the fourth interval, the second liquid outlet holes communicate with the second flow-uniformizing channels and the second region, the plurality of second liquid drain channels in the fourth region of the flow-uniformizing component communicate with the second region and the liquid outlet in the cover body, so that heat dissipation may be performed on the high heat flux region of the chip first, and then heat dissipation may be performed on the low heat flux region of the chip, thus improving the heat dissipation effect on the non-uniform heating chip. In addition, heat dissipation is performed on the chip through the heat dissipation apparatus provided by the present application, thermal stress brought by local temperature difference of the chip can be eliminated, and the service life and reliability of the chip are ensured.

### BRIEF DESCRIPTION OF DRAWING(S)

FIG. 1 is a schematic structural diagram of a heat dissipation apparatus disclosed by an embodiment of the present application;
FIG. 2 is a schematic structural diagram of a bottom board component disclosed by an embodiment of the present application;
FIG. 3 is a schematic diagram of arrangement of flow-uniformizing channels and liquid drain channels on a flow-uniformizing component disclosed by an embodiment of the present application;
FIG. 4 is a schematic diagram of a chip disclosed by an embodiment of the present application;
FIG. 5 is a schematic structural diagram of a heat conduction member disclosed by an embodiment of the present application;
FIG. 6 is a sectional view of a heat dissipation apparatus disclosed by an embodiment of the present application;
FIG. 7 is a schematic structural diagram of a flow jetting board disclosed by an embodiment of the present application;
FIG. 8 is a flowchart of a method for manufacturing a heat dissipation apparatus disclosed by an embodiment of the present application; and
FIG. 9 is a flowchart of processing a bottom board disclosed by an embodiment of the present application.

### DETAILED DESCRIPTION

Technical solutions in embodiments of the present application will be described clearly with reference to accompanying drawings in the embodiments of the present application below. Apparently, the described embodiments are part of the embodiments of the present application, not all the embodiments. Based on the embodiments of the present application, all other embodiments obtained by those ordinarily skilled in the art fall within the scope of protection of the present application.

Terms "first", "second" and the like in the description and claims of the present application are used to distinguish similar objects, but not used to describe a specific order or sequence. It should be understood that data used like this may be interchanged where appropriate, such that the embodiments of the present application may be implemented in an order other than those illustrated or described herein, the objects distinguished by "first", "second" and the like are usually of the same class, and the number of the objects is not limited, for example, there may be one or more first objects. In addition, "and/or" in the description and claims represents at least one of connected objects, and a character "/" generally represents that front and back associated objects are in an "or" relationship.

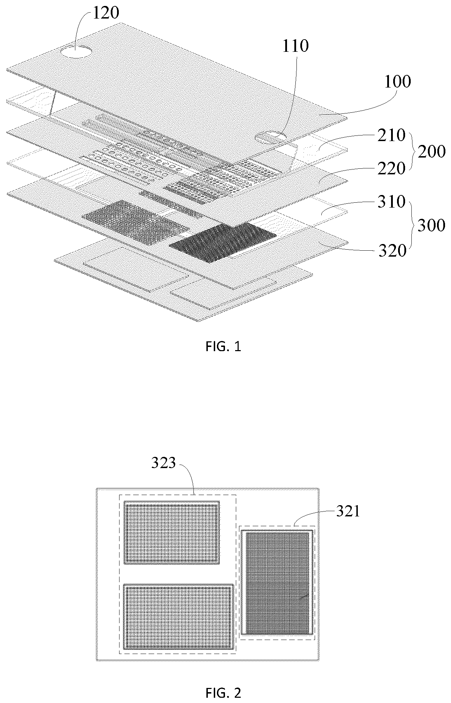

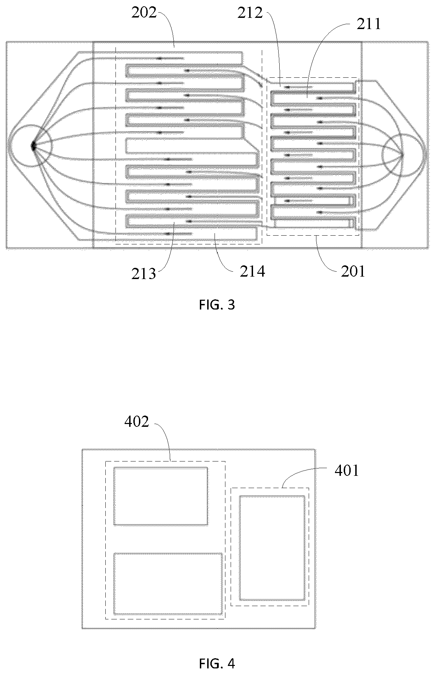

The present application discloses a heat dissipation apparatus and a method for manufacturing the heat dissipation apparatus. FIG. 1 is a schematic structural diagram of a heat dissipation apparatus disclosed by an embodiment of the present application. FIG. 2 is a schematic structural diagram of a bottom board component disclosed by an embodiment of the present application. FIG. 3 is a schematic diagram of arrangement of flow-uniformizing channels and liquid drain channels on a flow-uniformizing component disclosed by an embodiment of the present application. FIG. 4 is a schematic diagram of a chip disclosed by an embodiment of the present application.

As shown in FIG. 1 to FIG. 4, the heat dissipation apparatus disclosed by the present application includes: a cover body 100, a flow-uniformizing component 200 and a bottom board component 300, wherein the bottom board component 300 includes a heat dissipation chamber, a plurality of heat conduction members 322 are arranged in a first region 321 of the heat dissipation chamber at a first interval, a plurality of heat conduction members 322 are arranged in a second region 323 of the heat dissipation chamber at a second interval, wherein the first interval is smaller than the second interval; the flow-uniformizing component 200 at least covers the heat dissipation chamber, a third region 201 of the flow-uniformizing component 200 includes a plurality of first flow-uniformizing channels 211 and a plurality of first liquid drain channels 212, the first flow-uniformizing channels 211 and the first liquid drain channels 212 are arranged alternately, the first flow-uniformizing channels 211 are provided with a plurality of first liquid outlet holes 221 at a third interval, the first liquid outlet holes 221 communicate with the first flow-uniformizing channels 211 and the first region 321, a fourth region 202 of the flow-uniformizing component 200 includes a plurality of second flow-uniformizing channels 213 and a plurality of second liquid drain channels 214, the second flow-uniformizing channels 213 and the second liquid drain channels 214 are arranged alternately, the second flow-uniformizing channels 213 are provided with a plurality of second liquid outlet holes 223 at a fourth interval, the second liquid outlet holes 223 communicate with the second flow-uniformizing channels 213 and the second region 323, and the first liquid drain channels 212 communicate with the first region 321 and the second flow-uniformizing channels 213; the cover body 100 covers the flow-uniformizing component 200, the cover body 100 is provided with a liquid inlet 110 and a liquid outlet 120, the liquid inlet 110 communicates with the first flow-uniformizing channels 211, and the second liquid drain channels 214 communicate with the second region 323 and the liquid outlet 120; and in a case that a chip is in a mounted state, a face of the bottom board component 300 away from the flow-uniformizing component 200 makes contact with the chip, a fifth region 401 of the chip corresponds to the first region 321, a sixth region 402 of the chip corresponds to the second region 323, wherein a temperature of the fifth region 401 is higher than a temperature of the sixth region 402.

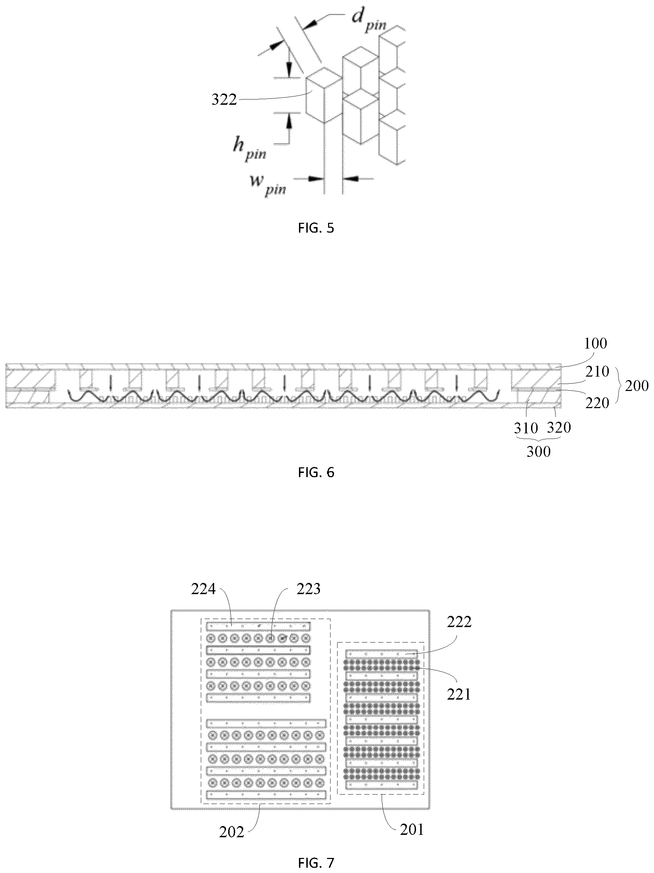

It needs to be noted that a height of each heat conduction member 322 is smaller than a height of the heat dissipation chamber, and for example, as shown in FIG. 5, the height hₚᵢₙ of each heat conduction member 322 may be 0.7 to 0.8 time the height of the heat dissipation chamber. In addition, a thickness of the cover body 100 may be 300-500 um, and diameters of the liquid inlet 110 and the liquid outlet 120 may be 5-8 mm.

The plurality of first flow-uniformizing channels 211 and the plurality of first liquid drain channels 212 in the third region 201 of the flow-uniformizing component 200 may be arranged alternatively in a preset direction of the flow-uniformizing component 200, for example, the first flow-uniformizing channels 211 and the first liquid drain channels 212 are arranged in the preset direction of the flow-uniformizing component 200 according to an order of 1, 3, and 5 being the first liquid drain channels 212 and 2, 4, and 6 being the first flow-uniformizing channels 211. One row or a plurality of rows of liquid outlet holes may be arranged along the flow-uniformizing channels. For example, the preset direction may be a direction perpendicular to a connecting line of the liquid inlet 110 and the liquid outlet 120 in the cover body 100. An arrangement manner of the plurality of second flow-uniformizing channels 213 and the plurality of second liquid drain channels 214 in the fourth region 202 of the flow-uniformizing component 200 is similar to an arrangement manner of the plurality of first flow-uniformizing channels 211 and the plurality of first liquid drain channels 212 in the third region 201 of the flow-uniformizing component 200, which is not repeated here.

In the present application, the cover body 100, the flow-uniformizing component 200 and the bottom board component 300 are stacked in sequence, relatively densely arranged heat conduction members 322 are arranged in the first region 321 corresponding to the high heat flux region of the chip of the bottom board component 300, such that a superficial area of the heat conduction members 322 in the first region 321 making contact with liquid is larger, relatively sparsely arranged heat conduction members 322 are arranged in the second region 323 corresponding to the low heat flux region of the chip of the bottom board component 300, such that a superficial area of the heat conduction members 322 in the second region 323 making contact with liquid is smaller, local high heat control of the chip can be implemented, at the same time, better temperature uniformity is kept, and the heat dissipation effect on the non-uniform heating chip is improved.

In addition, the third region 201 of the flow-uniformizing component 200 corresponds to the first region 321 of the bottom board component 300, the fourth region 202 of the flow-uniformizing component 200 corresponds to the second region 323 of the bottom board component 300, the plurality of first flow-uniformizing channels 211 in the third region 201 of the flow-uniformizing component 200 communicate with the liquid inlet 110 in the cover body 100, the first flow-uniformizing channels 211 are provided with the plurality of first liquid outlet holes 221 communicating with the first flow-uniformizing channels 211 and the first region 321 at a third interval, the plurality of first liquid drain channels 212 in the third region 201 of the flow-uniformizing component 200 communicate with the first region 321 and the plurality of second flow-uniformizing channels 213 in the fourth region 202 of the flow-uniformizing component 200, the second flow-uniformizing channels 213 are provided with the plurality of second liquid outlet holes 223 communicating with the second flow-uniformizing channels 213 and the second region 323 at a fourth interval, the plurality of second liquid drain channels 214 in the fourth region 202 of the flow-uniformizing component 200 communicate with the second region 323 and the liquid outlet 120 in the cover body 100, heat dissipation may be performed on the high heat flux region of the chip first, and then heat dissipation may be performed on the low heat flux region of the chip, more uniform heat dissipation is implemented, and the heat dissipation effect on the non-uniform heating chip is further improved.

When heat dissipation is performed on the chip arranged under the bottom board component 300 through the heat dissipation apparatus disclosed by the present application, as shown in FIG. 6, after flowing, through the liquid inlet 110 in the cover body 100, into the plurality of first flow-uniformizing channels 211 in the third region 201 of the flow-uniformizing component 200 for performing flow uniformizing, the liquid impacts perpendicularly on the first region 321 of the heat dissipation chamber with the heat conduction members 322 through the first liquid outlet holes 221 arranged in the first flow-uniformizing channels 211 to achieve distributed flow jetting, the heat conduction members 322 make contact with the liquid to perform heat conduction, and heat dissipation of the high heat flux region (namely the fifth region 401) of the chip is achieved. Then the liquid in the first region 321 of the heat dissipation chamber flows, through the plurality of first liquid drain channels 212 arranged in the third region 201 of the flow-uniformizing component 200, into the plurality of second flow-uniformizing channels 213 arranged in the fourth region 202 of the flow-uniformizing component 200 for performing flow uniformizing, after flow uniformizing, the liquid impacts perpendicularly on the second region 323 of the heat dissipation chamber with the heat conduction members 322 through the second liquid outlet holes 223 arranged in the second flow-uniformizing channels 213 to achieve distributed flow jetting, the heat conduction members 322 make contact with the liquid to perform heat conduction, and heat dissipation of the low heat flux region (namely the sixth region 402) of the chip is achieved. After heat dissipation of the chip is completed, the liquid in the second region 323 of the heat dissipation chamber flows out from the liquid outlet 120 in the cover body 100 through the plurality of second liquid drain channels 214 in the fourth region 202 of the flow-uniformizing component 200.

The present application adopts the design of the liquid outlet holes, can improve a flow rate of the liquid flowing downwards, then improve disturbance, and enhance heat transfer. The heat dissipation chamber can provide a mixed flow space, prolong a flow jetting route, and enhance the heat dissipation effect. In addition, the liquid flowing manner that the liquid enters the heat dissipation chamber through the flow-uniformizing channels and the liquid outlet holes of the flow-uniformizing component 200, impacts on the heat conduction members 322, then is rapidly reflected, and then is drained out through the liquid drain channels can keep a lower entire pressure drop at a higher flow rate.

The embodiment of the present application provides the heat dissipation apparatus, the relatively densely arranged heat conduction members 322 are arranged in the first region 321 of the heat dissipation chamber of the bottom board component 300, the relatively sparsely arranged heat conduction members 322 are arranged in the second region 323 of the heat dissipation chamber of the bottom board component 300, in the case where the chip is in the mounted state, the high heat flux region of the chip corresponds to the first region 321, the low heat flux region of the chip corresponds to the second region 323, in addition, the flow-uniformizing component 200 covers the heat dissipation chamber, the third region 201 of the flow-uniformizing component 200 corresponds to the first region 321 of the heat dissipation chamber, the fourth region 202 of the flow-uniformizing component 200 corresponds to the second region 323 of the heat dissipation chamber, the plurality of first flow-uniformizing channels 211 in the third region 201 of the flow-uniformizing component 200 communicate with the liquid inlet 110 in the cover body 100, the first flow-uniformizing channels 211 are provided with the plurality of first liquid outlet holes 221 at the third interval, the first liquid outlet holes 221 communicate with the first flow-uniformizing channels 211 and the first region 321, the plurality of first liquid drain channels 212 in the third region 201 of the flow-uniformizing component 200 communicate with the first region 321 and the plurality of second flow-uniformizing channels 213 in the fourth region 202 of the flow-uniformizing component 200, the second flow-uniformizing channels 213 are provided with the plurality of second liquid outlet holes 223 at the fourth interval, the second liquid outlet holes 223 communicate with the second flow-uniformizing channels 213 and the second region 323, the plurality of second liquid drain channels 214 in the fourth region 202 of the flow-uniformizing component 200 communicate with the second region 323 and the liquid outlet 120 in the cover body 100, heat dissipation can be performed on the high heat flux region of the chip first, and then heat dissipation is performed on the low heat flux region of the chip, thus improving the heat dissipation effect on the non-uniform heating chip. In addition, heat dissipation is performed on the chip through the heat dissipation apparatus provided by the present application, thermal stress brought by local temperature difference of the chip can be eliminated, and the service life and reliability of the chip are ensured.

In the present application, the heat conduction members may be microneedle teeth, adopting the microneedle teeth as the heat conduction members 322 can effectively enhance the entire heat transfer effect, and avoid the appearance of local hot spots, and meanwhile, implements better temperature control aiming at the high heat flux region. It needs to be noted that the microneedle teeth may be of a rectangular columnar structure, which is not specifically limited in the present application.

In an implementation, in a case that the heat conduction members 322 are of a rectangular columnar structure, an interval length among the heat conduction members 322 may be equal to a width of a bottom face of the rectangular columnar structure, that is to say, a width of a bottom face of the heat conduction members 322 arranged in the first region 321 is smaller than a width of a bottom face of the heat conduction members 322 arranged in the second region 323. In a case that the heat conduction members 322 are of a square columnar structure, an interval length among the heat conduction members 322 may be equal to an edge length of a bottom face square of the square columnar structure, that is to say, a bottom face square of the heat conduction members 322 arranged in the first region 321 is smaller than a bottom face square of the heat conduction members 322 arranged in the second region 323. For example, as shown in FIG. 5, an edge length dₚᵢₙ of the bottom face square of the heat conduction members 322 arranged in the first region 321 may be 10-100 um, the first interval wₚᵢₙ may be 10-100 um, an edge length dₚᵢₙ of the bottom face square of the heat conduction members 322 arranged in the second region 323 may be 100-200 um, and the second interval wₚᵢₙ may be 100-200 um. In addition, heights of the heat conduction members 322 arranged in the first region 321 and heights of the heat conduction members 322 arranged in the second region 323 may further be arranged according to actual heat dissipation requirements, for example, the heights of the heat conduction members 322 arranged in the first region 321 are set to be larger than the heights of the heat conduction members 322 arranged in the second region 323.

In the embodiment of the present application, since the relatively densely arranged heat conduction members 322 are arranged in the first region 321 of the heat dissipation chamber, the relatively sparsely arranged heat conduction members 322 are arranged in the second region 323 of the heat dissipation chamber, the third region 201 of the flow-uniformizing component 200 corresponds to the first region 321 of the heat dissipation chamber, and the fourth region 202 of the flow-uniformizing component 200 corresponds to the second region 323 of the heat dissipation chamber. By setting sizes of the first liquid outlet holes 221 of the third region 201 of the flow-uniformizing component 200 being smaller than sizes of the second liquid outlet holes 223 of the fourth region 202 of the flow-uniformizing component 200, and the third interval among the first liquid outlet holes 221 being smaller than the fourth interval among the second liquid outlet holes 223, namely, the first liquid outlet holes 221 of the third region 201 are arranged densely, the second liquid outlet holes 223 of the fourth region 202 are arranged sparsely, so that the liquid outlet holes in the flow-uniformizing component 200 can be matched with the heat conduction members 322 arranged in the heat dissipation chamber, and the heat dissipation effect on the chip is further improved.

In an implementation, the flow-uniformizing component 200 may include a liquid separation board 210 and a flow jetting board 220, the third region 201 of the liquid separation board 210 includes a plurality of first flow-uniformizing channels 211 and a plurality of first liquid drain channels 212, and the fourth region 202 of the liquid separation board 210 includes a plurality of second flow-uniformizing channels 213 and a plurality of second liquid drain channels 214. The third region 201 of the flow jetting board 220 includes a plurality of first liquid outlet holes 221 and a plurality of first liquid drain frames 222, and a fourth region 202 of the flow jetting board 220 includes a plurality of second liquid outlet holes 223 and a plurality of second liquid drain frames 224. The first liquid outlet holes 221 correspond to the first flow-uniformizing channels 211, the second liquid outlet holes 223 correspond to the second flow-uniformizing channels 213, the first liquid drain frames 222 correspond to the first liquid drain channels 212, the first liquid drain frames 222 communicate with the first liquid drain channels 212 and the first region 321, the second liquid drain frames 224 correspond to the second liquid drain channels 214, and the second liquid drain frames 224 communicate with the second liquid drain channels 214 and the second region 323.

In the present application, the flow-uniformizing component 200 may be composed of the liquid separation board 210 and the flow jetting board 220, a flow direction of the liquid in the liquid separation board 210 is shown in FIG. 3, the third region 201 of the liquid separation board 210 includes the plurality of first flow-uniformizing channels 211 and the plurality of first liquid drain channels 212, the fourth region 202 of the liquid separation board 210 includes the plurality of second flow-uniformizing channels 213 and the plurality of second liquid drain channels 214, and the arrangement of the plurality of first flow-uniformizing channels 211, the plurality of first liquid drain channels 212, the plurality of second flow-uniformizing channels 213 and the plurality of second liquid drain channels 214 herein is consistent with that in the above, which is not repeated here in the present application.

For example, a thickness of the liquid separation board 210 may be 1-1.5 mm, the plurality of first flow-uniformizing channels 211 may be of a rake-shaped structure, the plurality of first liquid drain channels 212 may be of a rake-shaped structure, the plurality of second flow-uniformizing channels 213 may be of a rake-shaped structure, the plurality of second liquid drain channels 214 may also be of a rake-shaped structure, a width of each flow-uniformizing channel may be 1-1.5 mm, and a width of each liquid drain channel may be 1-1.5 mm.

A structure of the flow jetting board 220 is shown in FIG. 7, the third region 201 of the flow jetting board 220 includes the plurality of first liquid outlet holes 221 and the plurality of first liquid drain frames 222, and the fourth region 202 of the flow jetting board 220 includes the plurality of second liquid outlet holes 223 and the plurality of second liquid drain frames 224. Arrangement of the first liquid outlet holes 221 corresponds to the first flow-uniformizing channels 211 of the liquid separation board 210, arrangement of the first liquid drain frames 222 corresponds to the first liquid drain channels 212, arrangement of the second liquid outlet holes 223 corresponds to the second flow-uniformizing channels 213 of the liquid separation board 210, and arrangement of the second liquid drain frames 224 corresponds to the second liquid drain channels 214 of the liquid separation board 210. For example, a thickness of the flow jetting board 220 may be 200-300 um.

In the embodiment of the present application, the bottom board component 300 may include a frame board 310 and a bottom board 320, the frame board 310 is provided with the heat dissipation chamber, a plurality of heat conduction members 322 are arranged in the first region 321 of the bottom board 320 at the first interval, and a plurality of heat conduction members 322 are arranged in the second region 323 of the bottom board 320 at the second interval.

For example, a thickness of the bottom board 320 may be 600-800 um, a thickness of the frame board 310 may be 200-300 um, and a height of the corresponding heat dissipation chamber may be 200-300 um.

In an implementation, the bottom board 320 may be made of silicon materials. Since the chip mounted under the bottom board 320 is a silicon substrate chip, the bottom board 320 is made of the silicon materials, when the chip is welded to the heat dissipation apparatus, the problem of risk of interface reliability brought by inconsistency of coefficients of thermal expansion of the materials can be avoided.

Optionally, the bottom board 320 may be formed by etching the chip.

In the embodiment of the present application, an area of an arrangement region of the heat conduction members 322 on the bottom board component 300 may be larger than an area of the chip, and then heat dissipation on the chip is better implemented.

In an implementation, the first liquid drain channels 212 and the second liquid drain channels 214 may be strip-shaped liquid drain frames, which can improve the flow-out rate of the liquid from the first region 321 or the second region 323 of the heat dissipation chamber.

In the embodiment of the present application, the above heat dissipation apparatus may further include a metal layer, and the metal layer is arranged between the bottom board component 300 and the chip. The metal layer may be formed by sequentially plating titanium, platinum and gold on a surface of the bottom board component 300 close to the chip or on the chip surface using a vapor deposition or magnetron sputtering technology. After metallization processing is completed, gold tin solders are attached on a welding face of the bottom board component 300 or the chip using an evaporation technology, and then a clamp is used to place the heat dissipation apparatus and the chip into an atmosphere furnace for heating fit, thus achieving assembly of the heat dissipation apparatus and the chip.

In a case that the bottom board component 300 is made of the silicon materials, titanium in the metal layer may play a role of increasing adhesivity, platinum in the metal layer may play a role of blocking titanium from leaking downwards, and gold may play a role of improving the weldability. In a case that the bottom board component 300 is made of non-silicon materials, the metal layer can separate the bottom board component 300 from the chip, avoiding the problem of risk of interface reliability brought by inconsistency of coefficients of thermal expansion of the materials.

In addition, the heat dissipation apparatus disclosed by the present application may be entirely packaged after being assembled with the chip, that is, the heat dissipation apparatus may be directly welded on a chip silicon wafer through a patch process, then the heat dissipation apparatus and the chip are entirely packaged, so as to reduce interface thermal resistance of the heat dissipation apparatus to the chip, and the heat dissipation effect on the chip is improved.

The heat dissipation apparatus disclosed by the present application may be used to perform heat dissipation on high-density isomerous chips, supervisor stack pointer (SSP) chips and the like.

It needs to be noted that the liquid described above may be water, a dielectric working medium or a refrigerant, etc., that is, the heat dissipation apparatus disclosed by the present application may use the water, the dielectric working medium or the refrigerant as a working medium.

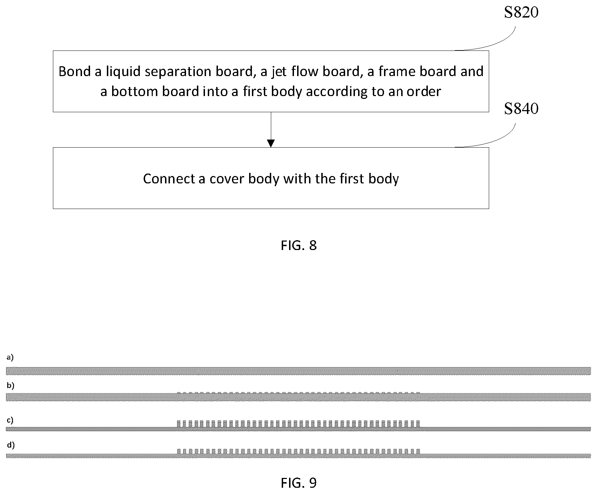

An embodiment of the present application further discloses a method for manufacturing a heat dissipation apparatus. As shown in FIG. 8, the manufacturing method includes:
S820: a liquid separation board 210, a flow jetting board 220, a frame board 310 and a bottom board 320 are bonded into a first body according to an order.
S840: a cover body is connected with the first body.

For example, the cover body 100 may be bonded to the first body using epoxy resin or shadowless glue (UV glue).

It needs to be noted that the liquid separation board 210, the flow jetting board 220, the frame board 310, the bottom board 320 and the cover body 100 herein are the liquid separation board 210, the flow jetting board 220, the frame board 310, the bottom board 320 and the cover body 100 described in the heat dissipation apparatus above.

Through the manufacturing method disclosed by the present application, considering size requirements of bonding, the liquid separation board 210, the flow jetting board 220, the frame board 310 and the bottom board 320 are bonded into the first body first according to the order, then the cover body 100 is connected with the first body, a processing difficult problem of the heat dissipation apparatus in a very small space size may be solved, and the manufacturing efficiency of the heat dissipation apparatus is improved.

In the embodiment of the present application, in order to facilitate bonding of the liquid separation board 210, the flow jetting board 220, the frame board 310 and the bottom board 320, the bottom board 320 and the flow jetting board 220 may be made of silicon materials, the frame board 310 and the liquid separation board 210 may be made of glass, that is, a structure of a layer of silicon, a layer of glass, a layer of silicon and a layer of glass. In addition, a material of the frame board 310 may further be polydimethylsiloxane (PDMS), and the cover body 100 may be made of glass.

In the present application, the bottom board 320, the frame board 310, the flow jetting board 220, the liquid separation board 210 and the cover body 100 are processed respectively, the bottom board 320 is processed through a deep silicon etching process, the frame board 310, the liquid separation board 210 and the cover body 100 are processed through a laser cutting process, and the flow jetting board 220 is processed through an etching process.

A flowchart of processing the bottom board 320 through the deep silicon etching process is shown in FIG. 9, including the following steps: (a) a photoetching mask board is designed according to a morphology of a needed heat conduction member; (b) spin coating of a photoresist is performed; (c) exposure is performed, and an exposure duration is changed based on a height of the needed heat conduction member; and (d) the photoresist is cleared to complete etching processing.

Focus descriptions in the above embodiments of the present application are differences among the embodiments, different optimization features of the embodiments may be combined to form preferable embodiments as long as they are not contradictory, and given the simplicity of the text, it will not be repeated here.

The above descriptions are only the embodiments of the present application, and are not used to limit the present application. For those skilled in the art, the present application may have various changes and variations. Any modification, equivalent replacement, improvement and the like within the spirit and principle of the present application should fall within the scope of the claims of the present application.

## Claims

1. A heat dissipation apparatus, comprising: a cover body, a flow-uniformizing component and a bottom board component, wherein
the bottom board component comprises a heat dissipation chamber, a plurality of heat conduction members are arranged in a first region of the heat dissipation chamber at a first interval, a plurality of heat conduction members are arranged in a second region of the heat dissipation chamber at a second interval, wherein the first interval is smaller than the second interval;
the flow-uniformizing component at least covers the heat dissipation chamber, a third region of the flow-uniformizing component comprises a plurality of first flow-uniformizing channels and a plurality of first liquid drain channels, the first flow-uniformizing channels and the first liquid drain channels are arranged alternately, the first flow-uniformizing channels are provided with a plurality of first liquid outlet holes at a third interval, the first liquid outlet holes communicate with the first flow-uniformizing channels and the first region, a fourth region of the flow-uniformizing component comprises a plurality of second flow-uniformizing channels and a plurality of second liquid drain channels, the second flow-uniformizing channels and the second liquid drain channels are arranged alternately, the second flow-uniformizing channels are provided with a plurality of second liquid outlet holes at a fourth interval, the second liquid outlet holes communicate with the second flow-uniformizing channels and the second region, and the first liquid drain channels communicate with the first region and the second flow-uniformizing channels;
the cover body covers the flow-uniformizing component, the cover body is provided with a liquid inlet and a liquid outlet, the liquid inlet communicates with the first flow-uniformizing channels, and the second liquid drain channels communicate with the second region and the liquid outlet; and
in a case that a chip is in a mounted state, a face of the bottom board component away from the flow-uniformizing component makes contact with the chip, a fifth region of the chip corresponds to the first region, a sixth region of the chip corresponds to the second region, wherein a temperature of the fifth region is higher than a temperature of the sixth region.

2. The heat dissipation apparatus according to claim 1, wherein a size of each first liquid outlet hole is smaller than a size of each second liquid outlet hole, and the third interval is smaller than the fourth interval.

3. The heat dissipation apparatus according to claim 1 or 2, wherein the flow-uniformizing component comprises a liquid separation board and a flow jetting board, a third region of the liquid separation board comprises the plurality of first flow-uniformizing channels and the plurality of first liquid drain channels, a fourth region of the liquid separation board comprises the plurality of second flow-uniformizing channels and the plurality of second liquid drain channels, a third region of the flow jetting board comprises the plurality of first liquid outlet holes and a plurality of first liquid drain frames, a fourth region of the flow jetting board comprises the plurality of second liquid outlet holes and a plurality of second liquid drain frames, the first liquid outlet holes correspond to the first flow-uniformizing channels, the second liquid outlet holes correspond to the second flow-uniformizing channels, the first liquid drain frames correspond to the first liquid drain channels, the first liquid drain frames communicate with the first liquid drain channels and the first region, the second liquid drain frames correspond to the second liquid drain channels, and the second liquid drain frames communicate with the second liquid drain channels and the second region.

4. The heat dissipation apparatus according to claim 1, wherein the bottom board component comprises a frame board and a bottom board, the frame board is provided with the heat dissipation chamber, a plurality of heat conduction members are arranged in a first region of the bottom board at a first interval, and a plurality of heat conduction members are arranged in a second region of the bottom board at a second interval.

5. The heat dissipation apparatus according to claim 4, wherein the bottom board is made of silicon materials.

6. The heat dissipation apparatus according to claim 5, wherein the bottom board is formed by etching a chip.

7. The heat dissipation apparatus according to claim 1, wherein an area of an arrangement region of the heat conduction members on the bottom board component is larger than an area of the chip.

8. The heat dissipation apparatus according to claim 1, wherein the first liquid drain channels and the second liquid drain channels are strip-shaped liquid drain frames.

9. The heat dissipation apparatus according to claim 1, further comprising a metal layer, wherein the metal layer is arranged between the bottom board component and the chip.

10. A method for manufacturing a heat dissipation apparatus, comprising:
bonding a liquid separation board, a flow jetting board, a frame board and a bottom board into a first body according to an order; and
connecting a cover body with the first body.

11. The manufacturing method according to claim 10, wherein the bottom board and the flow jetting board are made of silicon materials, and the frame board and the liquid separation board are made of glass.
